(19) Europäisches Patentamt
European Patent Office
Office européen des brevets

(11) **EP 4 704 268 A1**

(12) **EUROPEAN PATENT APPLICATION**
published in accordance with Art. 153(4) EPC

(43) Date of publication:
**04.03.2026   Bulletin 2026/10**

(51) International Patent Classification (IPC):
**H01S 5/10** (2021.01)      **H01S 5/065** (2006.01)

(21) Application number: **24795913.3**

(22) Date of filing: **17.04.2024**

(86) International application number:
**PCT/CN2024/088146**

(87) International publication number:
**WO 2024/222532 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:  **26.04.2023   CN 202310463008**
               **12.04.2024   CN 202410440863**

(71) Applicant: **Zhuhai Yingxun Xinguang Technology Co., Ltd.**
**Zhuhai, Guangdong 519000 (CN)**

(72) Inventor: **LI, Ruolin**
**Zhuhai, Guangdong 519000 (CN)**

(74) Representative: **Lorenz Seidler Gossel Part. mbB**
**Widenmayerstr. 23**
**80538 München (DE)**

(54)   **WAVELENGTH TUNING METHOD FOR SEMICONDUCTOR LASER**

(57)    A wavelength tuning method is disclosed for a semiconductor laser (701), the laser cavity (701) comprises an active light-emitting gain section (702), phase adjustment sections (703, 709), and a filtering feedback section (704). During laser wavelength tuning, relevant parameters such as the wavelength of the filtering feedback section (704) and phases of the phase adjustment sections (703, 709) follow the relationship of $\delta Lw / \delta Nr = (Lc - Lreff * Nr) / Nr$; wherein $\delta$ denotes a change, Lw represents the optical length of the phase adjustment sections (703, 709), Nr represents the effective optical refractive index of the filtering feedback section (704), Lreff represents the equivalent optical length of the filtering feedback section (704), and Lc represents the optical length of the laser cavity. When the wavelength of the tunable laser (701) is tuned, by constraining phase compensation of the phase adjustment sections (703, 709) of the laser to change according to the above said equation, mode hopping-free, continuous wavelength sweep of the semiconductor tunable laser can be achieved. Moreover, the laser wavelength changes linearly with the tuning of the filtering feedback section and the phase modulation.

FIG. 8

EP 4 704 268 A1

**Description**

**Technical Field**

The disclosure relates to a wavelength tuning method for a semiconductor laser, and particularly to a wavelength tuning method in a semiconductor external cavity tunable laser.

**Description of Related Art**

Semiconductor tunable lasers, due to their small footprint and size, high reliability, low cost, and unique optical performance, are widely used in various fields such as optical communication, sensing, measurement, and medical treatment, etc.

When being used in applications, a semiconductor tunable laser can be tuned to any required wavelength within its tunable wavelength coverage range. However, usually the wavelength tuning of these semiconductor tunable lasers is implemented in a discrete or step-like manner. If such a tunable laser is used in wavelength sweep applications, problems such as mode hopping may occur.

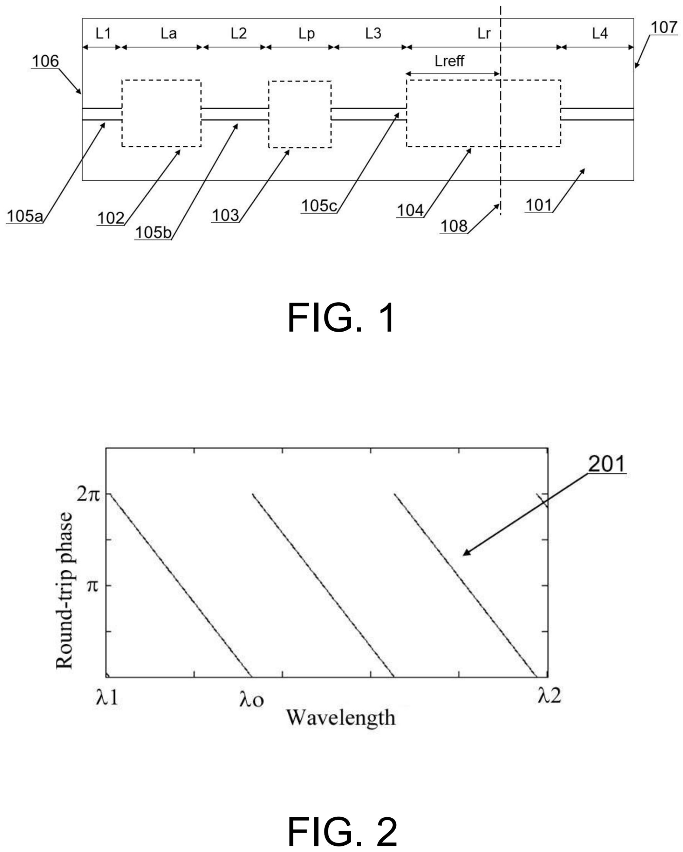

Semiconductor external cavity tunable lasers include, but are not limited to, Distributed Bragg Reflector (DBR) tunable lasers, Widely Tunable Sampled Grating Distributed Bragg Reflector (SGDBR) Lasers, Tunable Ring Resonator External Cavity Lasers, and External Cavity Tunable Lasers consisting of discrete components. Depending on the operating characteristics and physical optical requirements of the tunable laser itself, most chip-based semiconductor tunable lasers, such as Distributed Bragg Reflector (DBR) tunable lasers, Widely Tunable SGDBR Lasers, Ring Resonator based External Cavity Tunable Lasers, and External Cavity Tunable Lasers consisting of discrete components, mainly comprise, as shown in FIG. 1, an active light-emitting gain section 102, a waveguide phase adjustment section (or phase adjustment section) 103, an intra-cavity waveguide wavelength filtering and feedback reflector (or filtering feedback section) 104, and optical waveguides 105a-105c connecting them for light propagation. FIG. 1 is just an example of an external cavity laser structure; the aforementioned active light-emitting gain section, phase adjustment section, and filtering feedback section can also be in separate chip or device form integrated together to construct the external cavity laser.

The active light-emitting gain section 102 provides broadband photon emission and gain amplification as the photon source for the semiconductor tunable laser. The output lasing wavelength is determined by the reflection wavelength (center wavelength of the feedback peak) of the intra-cavity waveguide filtering feedback reflector 104. The waveguide phase adjustment section 103 is usually used to provide required phase adjustment or compensation for the lasing, so that the phase change of photons at such a wavelength traveling a round trip in the entire laser cavity or optical laser resonator ($102 \rightarrow 105b \rightarrow 103 \rightarrow 105c \rightarrow 108 \rightarrow 105c \rightarrow 103 \rightarrow 105b \rightarrow 102 \rightarrow 105a \rightarrow 106 \rightarrow 105a \rightarrow 102$) is an integer multiple of $2\pi$, to achieve constructive interference of light and thereby generate laser emission. The wavelength tuning process of the tunable laser is achieved by tuning the reflection wavelength of the intra-cavity waveguide filtering feedback reflector 104 to the designated wavelength, while accompanying a corresponding phase adjustments in the waveguide phase adjustment section 103 to ensure constructive optical interference at that wavelength for lasing.

The intra-cavity waveguide filtering feedback reflector 104 can be a Distributed Bragg Reflector (DBR), or a composite reflector comprising one or more waveguide ring resonators, waveguide Bragg gratings, or combinations thereof. The center reflection wavelength of the intra-cavity waveguide filtering feedback reflector 104 generally depends on the effective optical refractive index of its waveguide, which can be expressed as:

$$\lambda r = C * Nr * R \quad (1)$$

wherein Nr is the effective optical refractive index of the intra-cavity waveguide filtering feedback reflector 104, R is the period of the waveguide Bragg reflection grating or the radius of the waveguide ring resonators, and C is a proportionality constant. Typically, tuning of the reflection wavelength of the waveguide filtering feedback reflector is implemented by changing the effective optical refractive index of its waveguide via electro-optic or thermo-optic effects. Phase adjustment in the waveguide phase adjustment section 103 is also usually performed by changing the optical path length via the change in the effective optical refractive index of its waveguide through electro-optic or thermo-optic effects.

The reflection position of the intra-cavity waveguide filtering feedback reflector 104 can be represented by an equivalent optical reflection surface 108 in theory. In FIG. 1, 101 is a schematic illustration of a chip-integrated semiconductor laser: The left and right optical facets 106 and 107 of the chip 101 are coated with optical films of designated optical reflectivity; The effective optical refractive indices of the optical waveguides 105a (length L1), 105b (length L2), and 105c (length L3) on the chip are N1, N2, and N3, respectively; the effective optical refractive index of the active light-emitting gain section (optical waveguide length La) 102 is Na; the effective optical refractive index of the intra-cavity waveguide filtering feedback reflector (length Lr, equivalent optical length Lreff) 104 is Nr, and the effective optical refractive index of the waveguide phase adjustment section (length Lp) 103 is Np. If the left optical facet 106 of the chip 101 in FIG. 1 is coated with a high-reflection optical film, and the optical end facet 107 is coated with an anti-reflection optical film, then the right end facet 107 is the laser output end face, and the optical length of the laser cavity can be expressed as:

$$Lc = L1 * N1 + L2 * N2 + L3 * N3 + La * Na + Lreff * Nr + Lp * Np \qquad (2)$$

For photons with a wavelength equal to the center reflection peak wavelength $\lambda r$ of the reflector 104, the round-trip phase Pcavity in the cavity is expressed as:

$$Pcavity = (L1 * N1 + L2 * N2 + L3 * N3 + La * Na + Lreff * Nr + Lp * Np) * 2 * 2 * \pi / \lambda r \qquad (3)$$

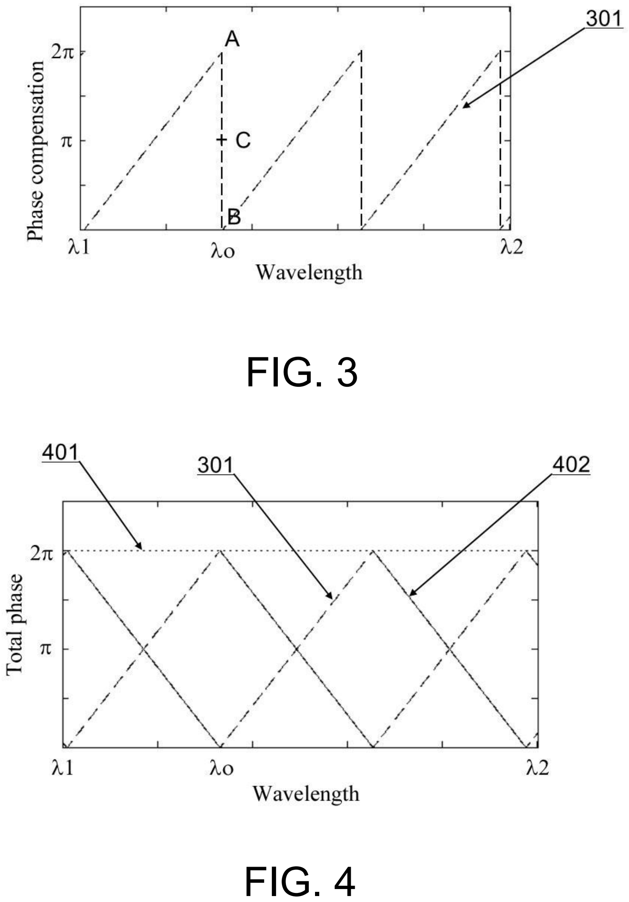

So if the reflection wavelength $\lambda r$ of the waveguide filtering feedback reflector 104 is changed or tuned, while other parts of the laser cavity remain unchanged, the round-trip phase of photons of that wavelength in the cavity, i.e., equation (3), changes periodically with the wavelength tuning, as shown by 201 in FIG. 2. Since integer multiples of $2\pi$ are equivalent to $2\pi$ for phase, FIG. 2 only shows the phase change within $2\pi$. Photons at a certain wavelength are able to constructively interfere to generate laser emission only when their round-trip phase change in the laser cavity is an integer multiple of $2\pi$, such as wavelength $\lambda 1$; at other wavelengths (between $\lambda 1$ and $\lambda 0$), either the laser emission is unstable, or the output power is small, or laser emission cannot occur (e.g., when the phase change is $\pi$). The role of the phase adjustment section 103 (as shown in FIG. 4) is to provide corresponding phase adjustment 301 (FIG. 4) along with the wavelength tuning 402 of the reflector 104, to ensure that the total round-trip phase 401 of the corresponding wavelength photons in the cavity remains an integer multiple of $2\pi$ (FIG. 4) as the reflection wavelength changes, generating optimal lasing emission. The phase adjustment of the phase section implemented through the change of its effective refractive index, Pphase_tune, can be expressed as:

$$Pphase\_tune = \delta Np * Lp * 2 * 2 * \pi / \lambda r \qquad (4)$$

wherein $\delta Np$ represents the change. Corresponding effective refractive index adjustment is performed to ensure the total phase of the photonics at lasing wavelength satisfy, i.e.:

$$Pphase\_tune + Pcavity = M * 2 * \pi \qquad \text{(where M is a positive integer)} \qquad (5)$$

However, currently typical phase compensation is periodic, meaning that the phase compensation method is not linear with respect to the wavelength change but periodic, exhibiting a sawtooth-like wave shape 301 as shown in FIGS. 3 and 4. Furthermore, when the laser operates in continuous working and tuning mode, due to the continuous periodic nature of phase compensation process, such phase compensation has jump points, such as A-C-B in FIG. 3, which will cause mode hopping to the laser (e.g., at C). Therefore, although the laser can tune to discrete wavelength continuously under such phase compensation method, it cannot deliver a stable, mode-hopping free wavelength sweep.

**SUMMARY**

An object of the disclosure is to provide a tuning method for a semiconductor tunable laser to achieve mode hopping-free, wavelength sweep in continuous mode.

To achieve the above objective, the technical solution proposed by the disclosure is as follows.

A wavelength tuning method for a semiconductor laser, wherein the laser cavity of the semiconductor laser is provided with an active light-emitting gain section, a phase adjustment section, and a filtering feedback section;

Specifically, during the laser wavelength tuning, relevant parameters such as the wavelength of the filtering feedback section and the phase of the phase adjustment section satisfy the following equation:

$$\delta Lw / \delta Nr = (Lc - Lreff * Nr) / Nr$$

wherein $\delta$ denotes the change, Lw represents the optical length of the phase adjustment section, Nr represents the effective optical refractive index of the filtering feedback section, Lreff represents the optical equivalent length of the filtering feedback section, and Lc represents the optical length of the laser cavity.

According to FIG. 1 and the derivation process in the Description of Related Art, it is obtained

$$Lc = L1 * N1 + L2 * N2 + L3 * N3 + La * Na + Lreff * Nr + Lp * Np = M * \lambda1 \quad (6)$$

when the constructive interference phase condition is satisfied at the initial wavelength $\lambda1$ for the laser.

Assuming all parts of the laser cavity, except the phase adjustment section 103 and the reflector 104, remain unchanged. To ensure the above condition still holds when the reflector wavelength is tuned by a amount of $\delta\lambda1$, namely, the wavelength changes from $\lambda1$ to $\lambda1 + \delta\lambda1$, it is obtained

$$\delta Lc = M * \delta\lambda1 \quad (7)$$

or

$$Lreff * \delta Nr + Lp * \delta Np = M * \delta\lambda1 \quad (8)$$

As mentioned above in eq. (1), the tuning of the center reflection wavelength of the reflector or the laser wavelength (for DBR or multi-ring resonator reflector structures) is generally proportional to the change of the effective refractive index of the reflector, i.e.:

$$\lambda1 = C * R * Nr \quad (9)$$

$$\delta\lambda1 = C * R * \delta Nr \quad (10)$$

From equations (8) and (9) it is obtained: $M * \lambda1 = (Lreff * \delta Nr + Lp * \delta Np) * C * R * Nr / \delta\lambda1 \quad (11)$
From equation (10), it is obtained:

$$C * R / \delta\lambda1 = 1 / \delta Nr \quad (12)$$

From equations (11) and (12), it is obtained:

$$M * \lambda1 = (Lreff * \delta Nr + Lp * \delta Np) * Nr / \delta Nr \quad (13)$$

Substituting equation (13) into equation (6) gives:

$$Lc = L1 * N1 + L2 * N2 + L3 * N3 + La * Na + Lreff * Nr + Lp * Np = Lreff * Nr + Lp * \delta Np * Nr / \delta Nr$$

Accordingly, it can be derived:

$$\delta Np * Lp / \delta Nr = (Lc - Lreff * Nr) / Nr \quad (14)$$

or

$$\delta Np * Lp / \delta Nr = (L1 * N1 + L2 * N2 + L3 * N3 + La * Na + Lp * Np) / Nr \quad (15)$$

That is to say, when the wavelength of the reflector 104 is tuned with an amount of $C * R * \delta Nr$, if the change of $\delta Np$ of the effective optical refractive index of the waveguide phase modulation sections varies synchronously following the ratio relation given above by equation (14) or (15), it can be ensured that during the laser wavelength tuning process, the round-trip phase of the phonons at corresponding wavelength remains an integer multiple of $2\pi$ within the laser cavity, achieving mode hopping-free operation during continuous wavelength tuning. Moreover, at same tiem, the laser wavelength changes linearly with the tuning of the reflector and the phase adjustment.

FIG. 1 shows the case where the active light-emitting gain section 102, the phase adjustment section 103, and the reflector 104 are arranged sequentially in the laser cavity. Actually, if the position of the phase adjustment section 103 changes, such as being placed before the active light-emitting gain section 102, the above equations (14) and (15) still hold, which will not be reiterated latter. Besides, $\delta Np * Lp$ in equations (14) and (15) represents $\delta Lw$, the change of amount of the optical length of the phase adjustment section.

The phase adjustment section is not limited to a single one; there can be multiple phase adjustment sections, and their overall performance can be effectively represented by a single phase adjustment section.

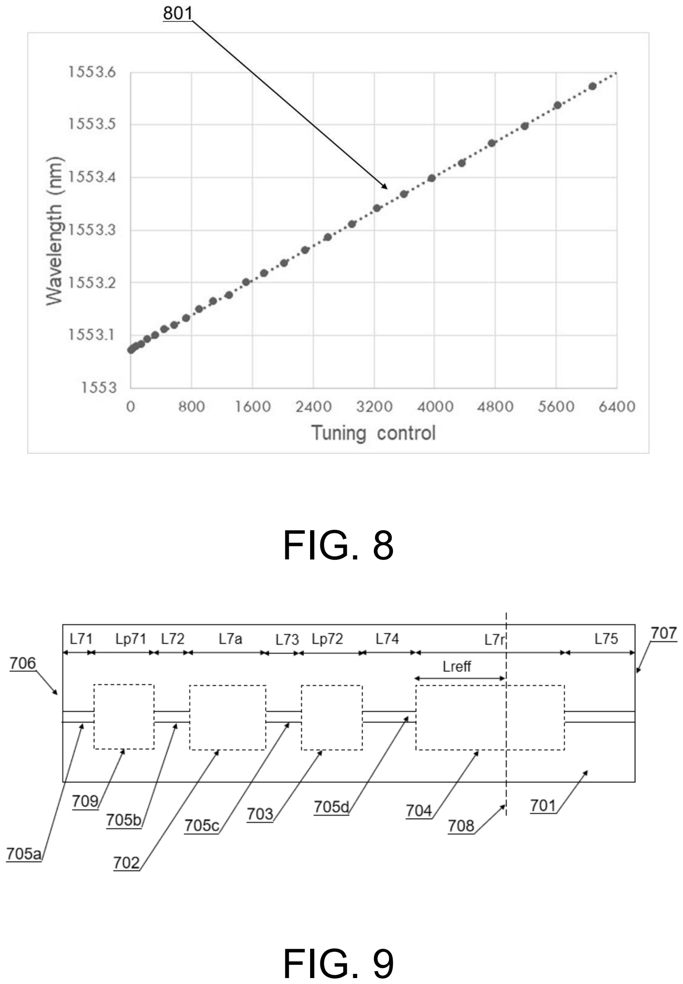

Shown in FIG. 9 is a chip-integrated semiconductor laser 701, in addition to an active light-emitting gain section 702, a filtering feedback section 704, and waveguide transmission sections 705a, 705b, 705c, 705d, it also includes multiple phase adjustment sections, namely phase adjustment sections 709 and 703, in its laser cavity. The facets 706 and 707 of the laser 701 are coated with optical films having designated reflectivities, 708 is the location of equivalent reflection surface of the filtering feedback section 704, and L71-L75, Lp71, L7a, Lp72, L7r, and Lreff represent the lengths of the corresponding structures.

At this time, the equality relations described by equations (6) and (8) can be reformulated accordingly to:

$$Lc = M * \lambda 1 \qquad (16)$$

$$Lreff * \delta Nr + Lp71 * \delta Np1 + Lp72 * \delta Np2 = M * \delta\lambda 1 \qquad (17)$$

wherein Np1 and Np2 are the effective optical refractive indices of the phase adjustment sections 709 and 703, respectively.

The equality relations described by equations (9) and (10) remain the same.

Thus, from equations (16), (17), (9), and (10), it can be obtained:

$$(Lp71 * \delta Np1 + Lp72 * \delta Np2) / \delta Nr = (Lc - Lreff * Nr) / Nr \qquad (18)$$

That is, when the wavelength of the filtering feedback section 704 is tuned with an amplitude of $C * R * \delta Nr$, if the amount of total optical length change $Lp71 * \delta Np1 + Lp72 * \delta Np2$ of the phase adjustment sections 709 and 703 changes synchronously following the relation defined by equation (18), it can also be ensured that during the laser wavelength tuning process, the round-trip phase of photons at the corresponding wavelength remains an integer multiple of $2\pi$ in the laser cavity, achieving mode hopping-free operation during continuous wavelength tuning, and the laser wavelength also change linearly with the tuning of the filtering feedback section and the phase adjustment.

Obviously, the above relationship can be easily extended to situations with more phase adjustment sections. At the same time, $Lp71 * \delta Np1 + Lp72 * \delta Np2$ in equation (18) also represents $\delta Lw$, the change of amount of optical length of the phase adjustment section(s).

Therefore, it is obvious that when the relevant parameters of the wavelength of the filtering feedback section and the phase of the phase adjustment section follow the relation of $\delta Lw / \delta Nr = (Lc - Lreff * Nr) / Nr$ during tuning, it can be ensured that during the laser wavelength tuning process, the round-trip phase of photons at the wavelength of the filtering feedback remains an integer multiple of $2\pi$ in the laser cavity, achieving mode hopping-free operation during continuous wavelength tuning, and the laser wavelength changes linearly with the tuning of the filtering feedback section and the phase modulation.

Additionally, it should be noted that the active light-emitting gain section, phase adjustment section, and filtering feedback section in FIG. 1 and FIG. 9 can also be discrete chips or components to be integrated together to construct an external cavity laser.

The filtering feedback section can comprise a Distributed Bragg Reflector (DBR), or a composite reflector comprising one or more waveguide ring resonators, waveguide Bragg gratings, sampled waveguide gratings, Arrayed Waveguide Gratings, MZI interferometers, or combinations thereof.

The semiconductor laser can be a tunable Distributed Bragg Reflector (DBR) laser, a Widely Tunable Sampled Grating Distributed Bragg Reflector (SGDBR) Laser, a Tunable Ring Resonator External Cavity Laser, or a discrete device External Cavity Tunable Laser.

The phase adjustment section and the filtering feedback section achieve phase and wavelength tuning by changing their effective optical refractive indices through electro-optic, thermo-optic, or other physical effects.

The beneficial effects and advantages are as follows.

The disclosure proposes a new tuning method. When the wavelength of the tunable laser is tuned, by constraining the phase adjustment section of the laser to perform phase compensation according to the above equation $\delta Lw / \delta Nr = (Lc - Lreff * Nr) / Nr$, compared with the prior art, mode hopping-free, continuous wavelength sweep of the semiconductor tunable laser can be achieved. Moreover, at same time, the laser wavelength changes linearly with the tuning of the filtering feedback section and the phase modulation.

## BRIEF DESCRIPTION OF THE DRAWINGS

FIG. 1 is a schematic structural diagram of a typical semiconductor external cavity tunable laser.

FIG. 2 is a schematic diagram showing the variation of the round-trip phase of photons within the cavity with wavelength in a tunable external cavity semiconductor laser.

FIG. 3 shows the profile of the typical optical phase adjustment to ensure that the round-trip phase of the photons is an integer multiple of $2\pi$ at discrete lasing wavelengths.

FIG. 4 shows that with the compensation by phase adjustment 301, the total round-trip phase 401 of photons within the cavity can be set to be an integer multiple of $2\pi$ at each tuning wavelength.

FIG. 5 is a schematic structural diagram of a silicon-based tunable external cavity laser of DBR structure.

FIG. 6 shows the change of lasing wavelength of the silicon-based tunable external cavity laser of DBR structure of FIG. 5 when only the waveguide reflector 506 is tuned individually, where the horizontal axis represents the change of tuning control (driver electrical power) through the heater electrode.

FIG. 7 shows that synchronous tuning of the waveguide reflector 506 and the waveguide phase section 504 according to equation (11) of the disclosure enables an uninterrupted continuous, mode hopping-free wavelength sweep.

FIG. 8 shows the uninterrupted continuous, mode hopping-free wavelength sweep change of the laser wavelength of the silicon-based tunable external cavity laser of DBR structure in FIG. 5 with the control of the waveguide reflector, when the waveguide reflector 506 and the waveguide phase section 504 are synchronously tuned according to equation (11) of the disclosure, where the horizontal axis represents the control (driver electrical power) of the heater electrode.

FIG. 9 is a schematic structural diagram of a typical semiconductor external cavity tunable laser. Compared with FIG. 1, the laser cavity here includes more than one phase control section.

## DETAILED DESCRIPTION OF DISCLOSED EMBODIMENTS

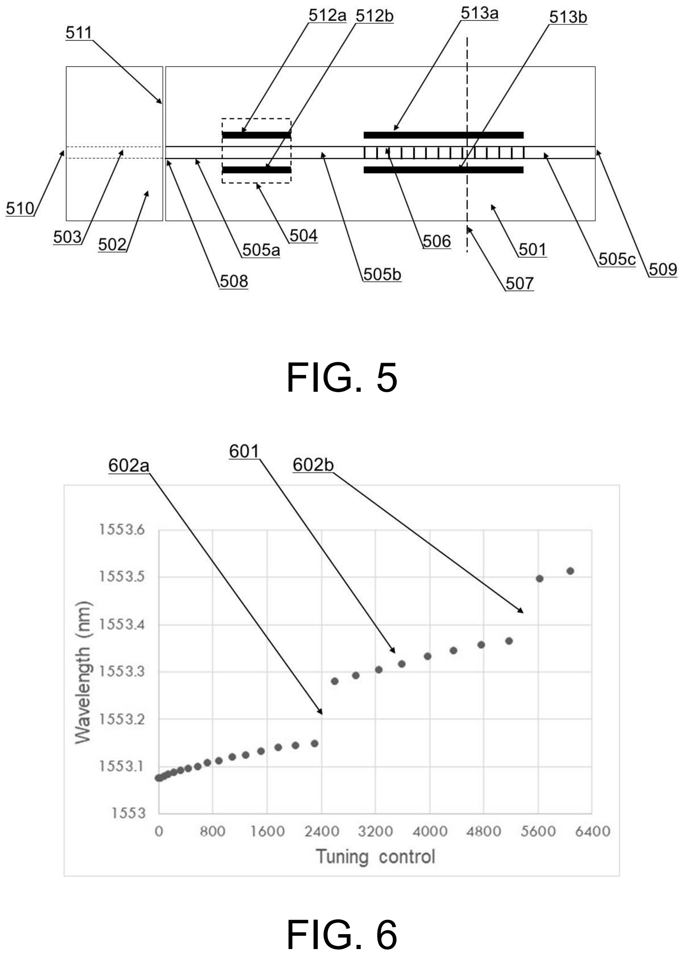

FIG. 5 is a top view of schematic diagram of a waveguide DBR external cavity laser based on hybrid integration of a silicon photonic chip used for experimental verification of the disclosure. An active gain chip 502 (compound semiconductor III-V active light-emitting gain chip, length La, effective optical refractive index Na) and a passive silicon photonic chip 501 are integrated through waveguide facets butt-coupling to construct the external cavity tunable laser. The waveguides and optical components between the left facet 510 of the active gain chip 502 and the waveguide reflector 506 (length Lr, effective optical refractive index Nr) of the passive chip 501 constitute the optical laser resonator, with 507 being its equivalent reflection position. The active gain chip 502 has an optical waveguide 503 thereon, and the right facet 511 is coated with an anti-reflection film of designated reflectivity. When being powered on, the active gain chip 502 generates photon emission through electro-optical conversion. The emitted photons propagate through the waveguide 503 and couple into the optical waveguide 505a (length L1, effective optical refractive index N1) of the passive silicon photonic chip 501. The passive silicon photonic chip 501 has optical waveguides 505a, a waveguide phase adjustment section 504 (length Lp, effective optical refractive index Np), a Distributed Bragg Reflector (DBR) or waveguide Bragg reflection grating 506, and connecting optical waveguides 505b (length L2, effective optical refractive index N2), 505c (length L3, effective optical refractive index N3). Local electrodes 512a, 512b are placed near the phase adjustment section 504 to change the effective optical refractive index of the waveguide by applying current, and local electrodes 513a, 513b are placed near the waveguide Bragg reflection grating 506 to change the effective optical refractive index of the waveguide by applying current. The local electrodes 512a, 512b, 513a, 513b alter the effective optical refractive index of the waveguide phase compensation section 504 or the waveguide Bragg reflection grating 506 through the thermo-optic effect. The left facets 508 and the right facets 509 of the passive silicon photonic chip 501 are coated with anti-reflection films of designated reflectivities.

In Experiment 1, the laser in FIG. 5 operates in an environment of constant temperature. First, while keeping the working conditions and settings of other parts of the silicon photonic hybrid integrated DBR external cavity laser unchanged, the heating power (tuning control) of the local electrodes 513a, 513b of the waveguide reflector 506 is changed to alter the temperature of the waveguide reflector, thereby change the effective optical refractive index of the reflector waveguide to tune its reflection wavelength. FIG. 6 shows the tuning change of the laser wavelength with the heating power (tuning control) of the local electrodes 513a, 513b. It can be seen that the laser wavelength is tuned 601 by the change of heating power (tuning control) of the local electrodes. Because heating electrodes 512a, 512b are not powered, i.e., no corresponding phase compensation is performed, the laser exhibits mode hopping near 1553.2 nm and 1553.45 nm during the wavelength tuning.

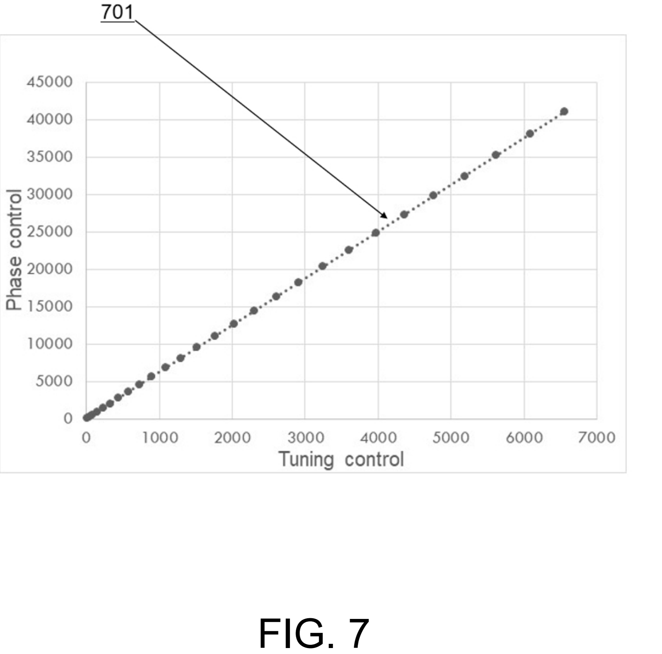

In Experiment 2, the laser in FIG. 5 operates in an environment of constant temperature. As shown in FIGS. 7 and 8, while keeping the working conditions and settings of other parts of the silicon photonic hybrid integrated DBR external cavity laser unchanged, the heating power 701 of the local electrodes 512a, 512b, 513a, 513b of the waveguide reflector 506 and the waveguide phase adjustment section 504 are synchronously changed according to the ratio equation (15) (L1=0 in the embodiment of FIG. 5) to change the local temperature of their waveguides, thereby change the effective optical refractive indices of corresponding waveguides of the reflector 506 and the phase adjustment section 504, to tune the laser wavelength of the laser. It can be seen that the laser wavelength changes linearly 801 with the heating power of the local electrodes. Due to the synchronization of phase compensation and the reflector tuning, the laser does not exhibit mode hopping near 1553.2 nm and 1553.45 nm, achieving continuous, linear, mode hopping-free laser frequency sweep 801.

The embodiment shown in FIG. 9 is also able to achieve continuous, linear, mode hopping-free laser scanning results similar to FIG. 5. The applicant believes that based on the verification of above embodiments, those skilled in the art can reasonably expect this, and no additional experimental verification data is provided here.

## Claims

1. A wavelength tuning method for a semiconductor laser, wherein a laser cavity of the semiconductor laser comprises an active light-emitting gain section, a phase adjustment section, and a wavelength filtering feedback reflection section;

   **characterized in that**, during laser wavelength tuning, relevant parameters such as wavelength of the filtering feedback section and a phase of the phase adjustment section follow a following equation:

   $$\delta Lw / \delta Nr = (Lc - Lreff * Nr) / Nr$$

   wherein $\delta$ denotes a change, Lw represents an optical length of the phase adjustment section, Nr represents an effective optical refractive index of the filtering feedback section, Lreff represents an optical equivalent length of the filtering feedback section, and Lc represents an optical length of the laser cavity.

2. The wavelength tuning method of claim 1, **characterized in that**, there exist one or more than one phase adjustment section.

3. The wavelength tuning method of claim 2, **characterized in that**, the filtering feedback section comprises a Distributed Bragg Reflector, or a composite reflector comprising one or more waveguide ring resonators, waveguide Bragg gratings, sampled waveguide gratings, Arrayed Waveguide Gratings, MZI interferometers, or combinations thereof.

4. The wavelength tuning method of claim 2, **characterized in that**, the semiconductor laser is a tunable Distributed Bragg Reflector laser, a Widely Tunable Sampled Grating Distributed Bragg Reflector Laser, a Tunable Ring Resonator External Cavity Laser, or a discrete device External Cavity Tunable Laser.

5. The wavelength tuning method of claim 2, **characterized in that**, the phase adjustment section and the filtering feedback section implement phase and wavelength tuning by changing their effective optical refractive indices through electro-optic or thermo-optic effects.

6. A wavelength tuning method for a semiconductor laser, wherein a laser cavity of the semiconductor laser comprises an active light-emitting gain section, a phase adjustment section, and a filtering feedback section;

   **characterized in that**, during laser wavelength tuning, relevant parameters of the wavelength of the filtering feedback section and the phase of the phase adjustment section follow a following equation:

   $$\delta Np / \delta Nr = (L1 * N1 + L2 * N2 + L3 * N3 + La * Na + Lp * Np) / (Nr * Lp)$$

   wherein $\delta$ denotes a change, Np represents an effective optical refractive index of the phase adjustment section, Lp represents a length of the phase adjustment section, Nr represents an effective optical refractive index of the filtering feedback section, Na represents an effective optical refractive index of the active light-emitting gain section, La represents a length of the active light-emitting gain section, L1, L2, L3 represent lengths of three optical waveguides to propagate the light between the right facet and the filtering feedback section of the laser along a laser emission direction, respectively, and N1, N2, N3 represent their effective optical refractive indices, accordingly.

7.  The wavelength tuning method of claim 6, **characterized in that**, the filtering feedback section comprises a Distributed Bragg Reflector, or a composite reflector comprising one or more waveguide ring resonators, waveguide Bragg gratings, sampled waveguide gratings, Arrayed Waveguide Gratings, MZI interferometers, or combinations thereof.

8.  The wavelength tuning method of claim 6, **characterized in that**, the semiconductor laser is a Distributed Bragg Reflector tunable laser, a Widely Tunable Sampled Grating Distributed Bragg Reflector Laser, a Tunable Ring Resonator External Cavity Laser, or a discrete device External Cavity Tunable Laser.

9.  The wavelength tuning method of claim 6, **characterized in that**, the phase adjustment section and the filtering feedback section achieve phase and wavelength tuning by changing their own effective optical refractive indices through electro-optic or thermo-optic effects.

# FIG. 1

# FIG. 2

FIG. 3

FIG. 4

# FIG. 5

# FIG. 6

701

FIG. 7

FIG. 8

FIG. 9

## INTERNATIONAL SEARCH REPORT

| International application No. |
| --- |
| **PCT/CN2024/088146** |

| A. | CLASSIFICATION OF SUBJECT MATTER |
| --- | --- |

H01S5/10(2021.01)i; H01S5/065(2006.01)i

According to International Patent Classification (IPC) or to both national classification and IPC

| B. | FIELDS SEARCHED |
| --- | --- |

Minimum documentation searched (classification system followed by classification symbols)

IPC: H01S5

Documentation searched other than minimum documentation to the extent that such documents are included in the fields searched

Electronic data base consulted during the international search (name of data base and, where practicable, search terms used)

CNTXT, ENTXT, ENTXTC, VEN, CNKI: 变, 波长, 补偿, 长度, 调, 反馈, 反射, 公式, 关系式, 光栅, 控, 滤波, 频, 跳模, 位相, 线性, 相干, 相位, 谐振, 折射率, DBR, tun+, wavelength, equation, reflect+, phase, resonat+, refractivity, linear, jump, mode, cohere+, compensat+

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2010050162 A (NIPPON TELEGRAPH & TELEPHONE CORP.) 04 March 2010 (2010-03-04)<br>entire document | 1-9 |
| A | JP H0832169 A (NEC CORP.) 02 February 1996 (1996-02-02)<br>entire document | 1-9 |
| A | US 2009059970 A1 (AXSUN TECHNOLOGIES, INC.) 05 March 2009 (2009-03-05)<br>entire document | 1-9 |
| A | US 2015255953 A1 (SANTEC CORP.) 10 September 2015 (2015-09-10)<br>entire document | 1-9 |
| A | CN 114024193 A (HUAZHONG UNIVERSITY OF SCIENCE AND TECHNOLOGY) 08 February 2022 (2022-02-08)<br>entire document | 1-9 |
| A | CN 101593931 A (ZHEJIANG UNIVERSITY) 02 December 2009 (2009-12-02)<br>entire document | 1-9 |

☐ Further documents are listed in the continuation of Box C.       ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **08 July 2024** | **18 July 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/088146**

| Patent document cited in search report | | | Publication date (day/month/year) | Patent family member(s) | | | Publication date (day/month/year) |
|---|---|---|---|---|---|---|---|
| JP | 2010050162 | A | 04 March 2010 | JP | 5001239 | B2 | 15 August 2012 |
| JP | H0832169 | A | 02 February 1996 | JP | 2687884 | B2 | 08 December 1997 |
| US | 2009059970 | A1 | 05 March 2009 | US | 2009059971 | A1 | 05 March 2009 |
| | | | | US | 8059277 | B2 | 15 November 2011 |
| | | | | US | 2012026505 | A1 | 02 February 2012 |
| | | | | US | 9337619 | B2 | 10 May 2016 |
| US | 2015255953 | A1 | 10 September 2015 | US | 9490607 | B2 | 08 November 2016 |
| | | | | WO | 2015183365 | A2 | 03 December 2015 |
| | | | | WO | 2015183365 | A3 | 21 January 2016 |
| CN | 114024193 | A | 08 February 2022 | None | | | |
| CN | 101593931 | A | 02 December 2009 | None | | | |

Form PCT/ISA/210 (patent family annex) (July 2022)